# EUROPÄISCHE PATENTSCHRIFT

(11) **EP 2 725 691 B1**
(45) Veröffentlichungstag und Bekanntmachung des Hinweises auf die Patenterteilung: **20.09.2017**
(21) Anmeldenummer: 12190392.6
(22) Anmeldetag: 29.10.2012
(51) Int. Cl.: H02K 11/40, H02K 11/02, H02K 5/128

(54) **Elektrisches Kfz-Nebenaggregat**
Auxiliary device for motor vehicle
Agrégat auxiliaire électrique d'un véhicule

(43) Veröffentlichungstag der Anmeldung: 30.04.2014
(73) Patentinhaber: Pierburg Pump Technology GmbH, 41460 Neuss (DE)
(72) Erfinder: Marzog, Ronny, 41464 Neuss (DE); Ruszczyk, Jakob, 50968 Köln (DE); Stevanovic, Predrag, 40667 Meerbusch (DE); Haase, Michael, 64711 Erbach (DE)
(74) Vertreter: Patentanwälte ter Smitten Eberlein-Van Hoof Rütten Partnerschaftsgesellschaft mbB

(56) Entgegenhaltungen:
- EP-A1- 2 187 718
- EP-A1- 2 476 914
- EP-A2- 2 053 726
- DE-A1- 19 728 291
- DE-A1-102006 050 067
- US-A- 5 982 253

## Beschreibung

Die Erfindung bezieht sich auf ein elektrisches Kfz-Nebenaggregat, beispielsweise auf eine elektrisch angetriebene Pumpe, insbesondere Flüssigkeits-Pumpe, auf ein elektrisches Ventil, eine elektrische Klappe oder andere elektrische Steller.

Die Vielzahl kleiner und größerer elektrischer Bauteile und Kfz-Nebenaggregate in einem Kraftfahrzeug stellt sehr hohe Anforderungen an die elektrische Entstörung der elektrischen Kfz-Nebenaggregate. Viele elektrische Nebenaggregate, insbesondere Pumpen, sind derart aufgebaut, dass eine Motorelektronik-Kammer, in der eine die Motorelektronik und insbesondere die Leistungselektronik zur Ansteuerung der Motorspulen aufweisende Motorelektronik-Platine angeordnet sind, an den elektrischen Antriebsmotor einschließlich der Motorspulen angrenzt. Der Antriebsmotor einschließlich der Motorspulen und die Motorelektronik-Kammer sind durch eine elektrisch leitende Metall- Trennwand voneinander getrennt,

Eine wichtige Maßnahme bei der elektrischen Entstörung ist ein guter und widerstandsarmer Massekontakt des elektrisch leitenden Gehäuses und der Schaltungsmasse auf der Motorelektronik-Platine miteinander und mit der elektrischen Fahrzeugmasse.

Aus EP 2 476 914 A1 ist ein als Kühlmittelpumpe ausgebildetes elektrisches Kfz-Nebenaggregat bekannt.

Aus EP 2 053 726 A2 ist ein mechanisch kommutierter Gleichstrommotor bekannt, bei dem die Motorbürsten über Entstördrosseln optional mit der Fahrzeugmasse bzw. der Fahrzeug-Batteriespannung verbunden sind.

Aus DE 19728291 ist ein dreiarmiger Masseverbinder zum elektrischen und mechanischen Verbinden einer Platine bzw. der Platinenmasse mit einem metallischen Gehäuse bekannt.

EP 2 187 718 offenbart eine elektrische Kühlmittelpumpe mit einer Motorelektronik-Platine, die mit ihrer nicht-bestückten Seite auf einer Trennwand fixiert ist.

US 5 982 253 A offenbart eine Entstörungsvorrichtung für einen elektronisch kommutierten Elektromotor mit einem elektrisch leitfähigen Gehäuse, wobei auf einer Entstörleiterplatte separate Kontaktinseln für Gehäusekontaktierung, Motoranschluss und Stromversorgung vorgesehen sind, die durch Filterelemente miteinander verbunden sind.

Aufgabe der Erfindung ist es, ein störungsfreies elektrisches Kfz-Nebenaggregat mit einem elektrischen Antriebsmotor zu schaffen.

Diese Aufgabe wird erfindungsgemäß gelöst mit einem elektrischen Kfz-Nebenaggregat mit den Merkmalen des Anspruchs 1.

Das elektrische Kfz-Nebenaggregat kann vorliegend grundsätzlich jeder Typ von Nebenaggregat sein, beispielsweise ein elektrisches Ventil, eine elektrische Klappe oder ein anderer elektrischer Steller, oder aber eine Fluidpumpe, insbesondere eine Flüssigkeitspumpe, insbesondere eine Schmiermittelpumpe, eine Kühlmittelpumpe oder eine Kraftstoffpumpe. Der Antriebsmotor kann als Trockenläufer, kann im Falle einer Flüssigkeitspumpe jedoch insbesondere auch als Nassläufer ausgebildet sein.

Das elektrische Kfz-Nebenaggregat weist einen elektrischen Antriebsmotor mit mehreren Motorspulen, eine durch den Antriebsmotor angetriebene Aggregatmechanik und eine Motorelektronik- Platine mit einer Motorelektronik zum Ansteuern des Antriebsmotors auf. Unter der Aggregatmechanik ist vorliegend die gesamte Aggregatmimik zu verstehen, also beispielsweise ein Getriebe im Falle eines Stellers, ein Pumpenrotor und Pumpenstator im Falle einer Pumpe et cetera.

Ferner ist ein elektrisches leitendes Nebenaggregat-Gehäuse vorgesehen, durch das der Antriebsmotor und die auf der Motorelektronik- Platine angeordnete Steuerungs- und Leistungselektronik elektrisch abgeschirmt werden.

Die Motorelektronik-Platine weist drei voneinander getrennte Masseinseln auf, nämlich eine Fahrzeugmasse-Insel, die über einen Masseanschluss des Nebenaggregats mit der Fahrzeugmasse verbunden werden kann, eine Schaltungsmasse-Insel, die über ein EMV-Filterelement mit der Fahrzeugmasse-Insel verbunden ist, und eine Gehäusemasse-Insel, die über ein EMV-Filterelement mit der Fahrzeugmasse-Insel verbunden ist. Die Gehäusemasse-Insel ist elektrisch mit dem Nebenaggregat-Gehäuse verbunden. Die Schaltungsmasse-Insel bildet das Masse-Potenzial für die gesamte Motorelektronik bzw. ist mit dieser elektrisch unmittelbar verbunden. Sowohl die Schaltungsmasse-Insel als auch die Gehäusemasse-Insel sind also nur mittelbar jeweils über ein EMV-Filterelement mit der Fahrzeugmasse-Insel verbunden, die wiederum über einen Masseanschluss-Stecker mit der Fahrzeugmasse verbunden werden kann. Ein EMV-Filterelement ist insbesondere als ein passiver RC-Filter ausgebildet, kann jedoch grundsätzlich jeder andere passive oder aktive Filterelement-Typ sein. Das EMV-Filterelement sollte bevorzugt insbesondere hochfrequente Störungen eliminieren bzw. daran hindern, zur Fahrzeugmasse übertragen zu werden.

Wie Versuche ergeben haben, kann durch die Zwischenschaltung der EMV-Filterelemente zwischen die Fahrzeugmasse einerseits und die Schaltungsmasse sowie die Gehäusemasse andererseits die elektromagnetische Verträglichkeit des Kfz-Nebenaggregats insgesamt spürbar verbessert werden.

Vorzugsweise ist in dem Nebenaggregat-Gehäuse eine elektrisch leitende Trennwand angeordnet, die elektrisch mit dem elektrisch leitenden Gehäuse verbunden ist. Die Trennwand trennt eine Motorelektronik-Kammer, in der die Motorelektronik-Platine mit der Motorelektronik angeordnet ist, von dem Antriebsmotor und/oder der Aggregatmechanik. Die Trennwand stellt eine weitere Abschirmung dar, die beispielsweise unmittelbar an die Motorelektronik-Platine angrenzt und auf diese Weise eine besonders wirkungsvolle elektromagnetische Abschirmung darstellt.

Vorzugsweise ist die Aggregatmechanik eine Flüssigkeitspumpe mit einem Pumpenrotor und einem Pumpenstator, wobei die Trennwand durch die Flüssigkeit, die von der Flüssigkeitspumpe gepumpt wird, unmittelbar gekühlt wird. Dies kann konstruktiv dadurch erreicht werden, dass die Flüssigkeitspumpe unmittelbar angrenzt an die Trennwand, so dass die Flüssigkeit die Trennwand ständig umspült und mit einer hohen Kühlleistung kühlt. Alternativ kann der Antriebsmotor an die Trennwand angrenzen, wobei der Motorrotor als Nassläufer ausgebildet ist. Die den Motorrotor umgebende Flüssigkeit spült und kühlt auf diese Weise auch unmittelbar die Trennwand.

Die Motorelektronik auf der Motorelektronik-Platine weist zum Ansteuern der Motorspulen Leistungshalbleiter auf, die, je nach Bauart, eine Eigentemperatur von 120-150 °C nicht überschreiten dürfen, da sie oberhalb dieser Temperatur zerstört werden. Da die Motorelektronik in der Regel in einer hermetisch geschlossenen Motorelektronik-Kammer sitzt, um eine gute elektromagnetische Verträglichkeit sicherzustellen und um die Motorelektronik gegen äußere Einflüsse zu schützen, ist eine Kühlung über das ausschließlich luftgekühlte Gehäuse nur begrenzt möglich. Durch das Spülen einer Trennwand-Seite mit der Pumpenflüssigkeit wird die Kühlleistung erheblich erhöht.

Gemäß einer bevorzugten Ausgestaltung ist die Fahrzeugmasse-Insel am Rand der Motorelektronik-Platine und unmittelbar an das Gehäuse angrenzend auf der Motorelektronik-Platine angeordnet. Hierdurch wird die Leistungsverbindung zwischen der Fahrzeugmasse-Insel einerseits und der fahrzeugseitigen Masseanbindung andererseits möglichst kurz gehalten, was wiederum die elektromagnetische Verträglichkeit insgesamt verbessert. Unter einer Anordnung am Rand der Motorelektronik-Platine bzw. unmittelbar an das Gehäuse angrenzend ist jeweils eine Entfernung von weniger als 15 mm, besonders bevorzugt von weniger als 10 mm zu verstehen.

Vorzugsweise ist der Masseanschluss von der Fahrzeugmasse-Insel aus ungefähr radial durch das Gehäuse nach außen geführt. Hierbei wird von einem ungefähr zylindrisch ausgebildeten Gehäuse ausgegangen, das eine Längsachse aufweist, um die sich der Antriebsmotor dreht. Die Masseanschiuss-Leitung ist von der Fahrzeugmasse-Insel auf der Motorelektronik-Platine aus etwa radial nach außen geführt, und kann in einem entsprechenden Masseanschluss-Stecker münden. Die radiale Anordnung der Masseanschiuss-Leitung stellt die kürzestmögliche Verbindung nach außen, und damit zu der fahrzeugseitigen Fahrzeugmasse dar.

Gemäß einer bevorzugten Ausgestaltung ist die Gehäusemasse-Insel über einen Blattfederkontakt elektrisch unmittelbar mit dem Nebenaggregat-Gehäuse verbunden. Einen Blattfederkontakt besteht aus einem elektrisch leitenden Metallblech, ist elastisch und plastisch in weiten Bereichen verformbar, und stellt eine mechanisch belastbare und nachgiebige elektrische Verbindung dar, so dass ein niedriger Übergangswiderstand auch über die gesamte Lebensdauer des Nebenaggregats sichergestellt werden kann. Eine unmittelbare Kontaktierung der Gehäusemasse-Insel mit dem Gehäuse, bei der die Motorelektronik-Platine entsprechend dauerhaft verformt werden müsste, entfällt, so dass durch diese Maßnahme auch die Zuverlässigkeit und Lebensdauer der Motorelektronik-Platine verbessert wird.

Vorzugsweise ist der Blattfederkontakt brückenartig ausgebildet und in einer entsprechenden Kontaktöffnung der Platine angeordnet. Durch das vorsehen der Kontaktöffnung in der Platine ist der Blattfederkontakt einfach zugänglich und kann auch noch nach der Montage der Motorelektronik-Platine auf der Trennwand mit einfachen Mitteln, beispielsweise durch eine Schraube mit dem Gehäuse oder der Trennwand elektrisch verbunden werden. Der Blattfederkontakt ist mit seinen beiden Längsenden mit der Gehäusemasse-Insel verbunden. Der langgestreckt ausgebildete Blattfederkontakt überbrückt also eine entsprechende Kontaktöffnung in der Platine. Dadurch, dass der Blattfiederkontakt mit zwei Enden mit der Gehäusemasse-Insel elektrisch verbunden ist, wird eine hohe mechanische und elektrische Sicherheit und Zuverlässigkeit der mechanischen und elektrischen Verbindung zwischen der Gehäusemasse-Insel und dem Blattfederkontakt realisiert.

Gemäß einer bevorzugten Ausgestaltung ist die Motorelektronik-Platine mit ihrer nicht-bestückten Seite auf der Trennwand fixiert, und ist die Gehäusemasse-Insel über den Blattfederkontakt elektrisch unmittelbar mit der Trennwand verbunden. Besonders bevorzugt ist die Motorelektronik-Platine über eine elektrisch nicht-leitende Wärmeleitschicht mit einer definierten konstanten Dicke D mit der Trennwand verbunden. Während die Motorelektronik-Platine also mit einem Abstand D beanstandet über der Trennwand angeordnet ist, wird die elektrische Masseverbindung zwischen der Gehäusemasse-Insel und der Trennwand über den biegsamen und elastischen Blattfiederkontakt hergestellt. Die Wärmeleitschicht kann von einer Wärmeleitpaste gebildet werden, kann aber auch von einem Wärmeleitkleber gebildet werden, der die Motorelektronik-Platine auf der Trennwand bleibend fixiert.

Die Dicke D der Wärmeleitschicht muss in einem relativ engen Bereich liegen, um einen größtmöglichen Wärmefluss sicherzustellen. Ferner muss hierfür ebenfalls sichergestellt werden, dass die Wärmeleitschicht homogen und frei von Lufteinschlüssen ist. Gemäß einer bevorzugten Ausgestaltung werden daher die Dicke D und die Homogenität der Wärmeleitschicht kapazitiv bestimmt, und zwar, indem die elektrische Kapazität zwischen der Trennwand einerseits und einer Leiterbahnfläche auf der Messeelektronik-Platine andererseits bestimmt wird, wobei Letztere bevorzugt von der Leiterbahn der Schaltungsmasse gebildet wird. Während der Kapazitäts-Messung ist der Blattfederkontakt noch nicht mit der Trennwand verbunden. Erst nach Abschluss der Kapazitätsmessung wird der Blattfederkontakt elektrisch leitend mit dem Gehäuse verbunden beispielsweise durch eine elektrisch leitende Verbindungsschraube mit der Trennwand verbunden. Auf diese Weise wird eine einfache Kapazitätsmessung zur Qualitätskontrolle der Wärmeleitschicht und andererseits eine einfache, kurze und zuverlässige Masseanbindung der Gehäusemasse-Insel mit dem Gehäuse realisiert.

Im Folgenden wird unter Bezugnahme auf die Zeichnungen ein Ausführungsbeispiel der Erfindung näher erläutert. Es zeigen:
Figur 1 einen Längsschnitt eines elektrischen Kfz-Nebenaggregats einschließlich einer Motorelektronik-Platine, und
Figur 2 eine Draufsicht auf die Motorelektronik-Platine des elektrischen Kfz-Nebenaggregats der Figur 1.

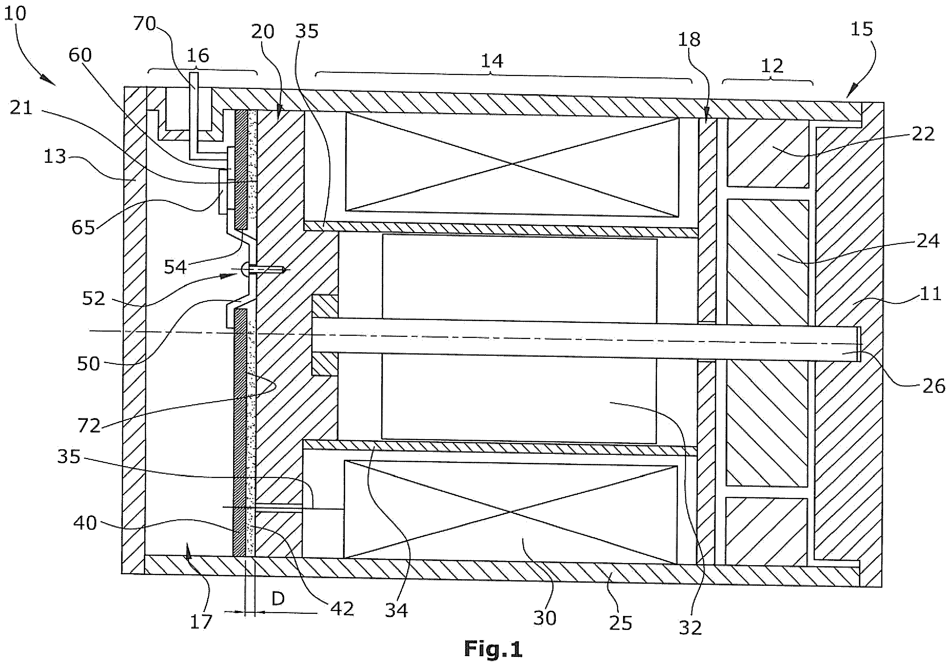

In der Figur 1 ist ein elektrisches Kfz-Nebenaggregat 10 dargestellt, das vorliegend als elektrische Kühlmittelpumpe ausgebildet ist. Grundsätzlich kann das elektrische Kfz-Nebenaggregat aber auch als elektrische Pumpe anderen Typs ausgebildet sein, als ein elektrisches Ventil, eine elektrische Klappe oder als ein anderer Nebenaggregat-Typ ausgebildet sein.

Das vorliegende elektrische Kfz-Nebenaggregat 10 ist, in Längsrichtung gesehen, aufgeteilt in die Bereiche Aggregatmechanik 12, die vorliegend einen Pumpenrotor 24 und einen Pumpenstator 22 aufweist, elektrischer Antriebsmotor 14, der im Wesentlichen von mehreren statorseitigen Motorspulen 30 und einem permanent erregten Motorrotor 32 gebildet wird, und einen Motorelektronik-Abschnitt 16. In dem Motorelektronik-Abschnitt 16 ist eine Motorelektronik-Kammer 17 vorgesehen, in der eine Motorelektronik-Platine 40 angeordnet ist. Die Motorelektronik-Platine 40 weist die Steuerungs- und Leistungselektronik 37 zum Steuern und Regeln des Antriebsmotors 14 und insbesondere zum Ansteuern der Motorspulen 30 auf. Die Motorspulen 30 sind über mehrere Verbindungsleitungen 35 mit der Motorelektronik-Platine 40 elektrisch verbunden.

Der Pumpenrotor 24 und der Motorrotor 32 sitzen auf einer Rotorwelle 26. Der Antriebsmotor 14 weist ein zylindrisches Spaltrohr 34 auf, das den Nassbereich, in dem der Motorrotor 32 angeordnet ist, trennt von dem ringförmigen Trockenbereich, in dem die Motorspulen 30 angeordnet sind. Der Antriebsmotor 14 ist also als sogenannter Spaltrohrmotor bzw. als Nassläufer ausgebildet.

Das Kfz-Nebenaggregat 10 weist ein Gehäuse 15 auf, dass im Wesentlichen von einem zylindrischen Gehäusezylinder 25, einem pumpenseitigen Gehäusedeckel 11 und einem elektronikseitigen Gehäusedeckel 13 gebildet wird. Innerhalb des Gehäuses 15 ist eine interne Trennwand 18 vorgesehen, die in einer Querebene steht und den Pumpenraum der Aggregatmechanik 12 gegenüber dem Antriebsmotor 14 weitgehend abschließt. Allerdings kann die von der Aggregatmechanik 12 gepumpte Flüssigkeit auch in den Nassraum hinein- und aus diesem wieder herausfließen. Ferner ist innerhalb des Nebenaggregat-Gehäuses 15 eine weitere in einer Querebene liegende Trennwand 20 angeordnet, die die Motorelektronik-Kammer 16 hermetisch von dem Antriebsmotor 14 trennt. Alle Teile des Gehäuses 15 sowie die Trennwand 20 sind aus elektrisch leitendem Metall hergestellt, beispielsweise aus Aluminium.

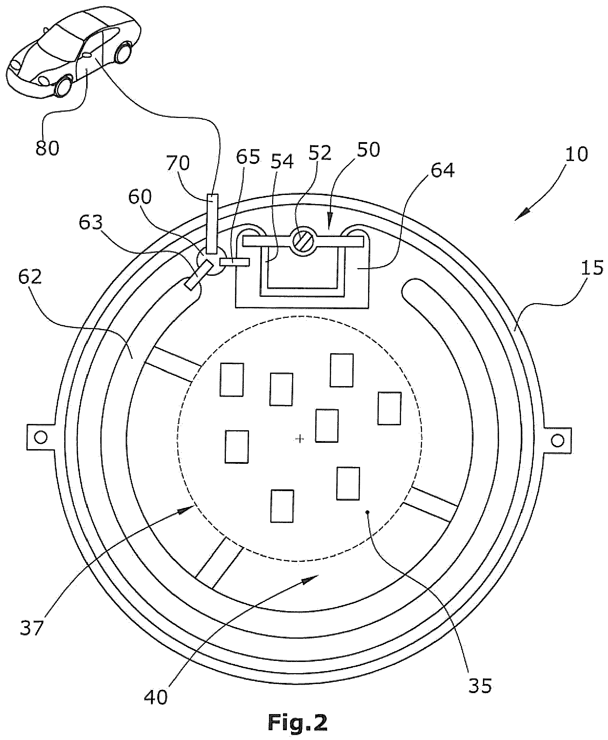

Insbesondere in der Figur 2 ist der Aufbau der Motorelektronik-Platine 40 genau erkennbar. Am Rand der Motorelektronik-Platine 40 ist eine elektrisch leitende Fahrzeugmasse-Insel 60 angeordnet, die mit einem als Stecker ausgebildeten Fahrzeug-Masseanschluss 70 verbunden ist. Der Fahrzeug-Masseanschluss 70 kann mit der Fahrzeugmasse 80 verbunden werden, sobald das elektrische Kfz-Nebenaggregat 10 in das betreffende Fahrzeug eingebaut ist. Auf der Motorelektronik-Platine 40 sind ferner eine Schaltungsmasse-Insel 62 und eine Gehäusemasse-Insel 64 vorgesehen, die jeweils über ein als RC- Filter ausgebildetes EMV-Filterelement 63 bzw. 65 mit der Schaltungsmasse-Insel 62 verbunden sind.

Die Motorelektronik-Platine 40 ist mit einer Wärmeleitschicht 42, die als Wärmeleitkleber ausgebildet ist, in einer definierten konstanten Dicke D beanstandet zu mit der Trennwand 20 wärmeleitend verklebt.

Die Motorelektronik-Platine weist eine als seitliche Ausnehmung ausgebildete Kontaktöffnung 54 auf, die von einem brückenartig ausgebildeten Blattfederkontakt 50 überspannt ist, der mit seinen beiden Längsenden mit der U-förmlg um die Kontaktöffnung 54 herumgeführten Gehäusemasse-Insel 64 elektrisch verbunden, beispielsweise verlötet ist. Der Blattfederkontakt 50 ist, in Gerätelängsrichtung gesehen, federnd ausgebildet, und mit einer Verbindungsschraube 52 mittig und elektrisch leitend mit der Trennwand 20 verschraubt.

Bei der Montage des Nebenaggregats 10 wird nach dem Aufbringen des Wärmeleitklebers auf die distale Seite der Trennwand 20 die Motorelektronik-Platine 40 auf den Wärmeleitkleber aufgebracht, so dass zwischen der Platine 40 und der Trennwand 20 eine Wärmeleitschicht 42 einer Dicke D gebildet wird. Die Dicke D und die Homogenität der Wärmeleitschicht 42 wird kapazitiv bestimmt, und zwar, indem die elektrische Kapazität zwischen der Trennwand 20 und der Schaltungsmasse-Insel 62 bestimmt wird. Wenn die gemessene elektrische Kapazität innerhalb eines zulässigen Bereichs liegt, wird davon ausgegangen, dass die Homogenität und die Dicke D der Wärmeleitschicht 42 optimal sind. Erst anschließend wird der Blattfederkontakt 50, der bis dahin keinen elektrischen Kontakt zu der Trennwand 20 hatte, auf die Trennwand 20 gedrückt und mit der Verbindungsschraube 52 mechanisch und elektrisch mit der Trennwand 20 verbunden.

## Patentansprüche

1. Elektrisches Kfz-Nebenaggregat (10) mit
einem elektrischen Antriebsmotor (14) mit statorseitigen Motorspulen (30),
einer durch den Antriebsmotor (14) angetriebenen Aggregatmechanik (12),
einer Motorelektronik-Platine (40) mit einer Steuerungs- und Leistungselektronik (37) aufweisenden Motorelektronik zum Steuern des Antriebsmotors (14), und
einem elektrisch leitenden Nebenaggregat-Gehäuse (15),
wobei die Motorelektronik-Platine (40) aufweist:
eine Fahrzeugmasse-Insel (60), die über einen Masseanschluss (70) mit der Fahrzeugmasse (80) verbunden werden kann, eine Schaltungsmasse-Insel (62), die über ein als RC-Filter ausgebildetes EMV-Filterelement (63) mit der Fahrzeugmasse-Insel (60) verbunden ist, und
eine Gehäusemasse- Insel (64), die über ein als RC-Filter ausgebildetes EMV-Filterelement (65) mit der Fahrzeugmasse-Insel (60) verbunden ist.

2. Elektrisches Kfz-Nebenaggregat (10) nach Anspruch 1, wobei in dem Nebenaggregat-Gehäuse (15) eine mit dem Gehäuse (15) elektrisch verbundene und elektrisch leitende Trennwand (20) angeordnet ist, die eine Motorelektronik-Kammer (17) von dem Antriebsmotor (14) und/oder der Aggregatmechanik (12) trennt.

3. Elektrisches Kfz-Nebenaggregat (10) nach Anspruch 2, wobei die Aggregatsmechanik (12) eine Flüssigkeitspumpe mit einem Pumpenrotor (24) und einem Pumpenstator (22) ist, wobei die Trennwand (20) durch die Flüssigkeit, die von der Flüssigkeitspumpe gepumpt wird, unmittelbar gekühlt wird.

4. Elektrisches Kfz-Nebenaggregat (10) nach einem der vorangegangenen Ansprüche, wobei die Fahrzeugmasse-Insel (60) am Rand der Platine (40) und unmittelbar an das Gehäuse (15) angrenzend auf der Platine (40) vorgesehen ist.

5. elektrisches Kfz-Nebenaggregat (10) nach dem vorangegangenen Anspruch, wobei ein Masseanschluss (70) von der Fahrzeugmasse-Insel (60) ungefähr radial durch das Gehäuse (15) nach außen geführt ist.

6. Elektrisches Kfz-Nebenaggregat (10) nach einem der vorangegangenen Ansprüche, wobei die Gehäusemasse-Insel (60) über einen Blattfederkontakt (50) elektrisch unmittelbar mit dem Nebenaggregat-Gehäuse (15) verbunden ist.

7. Elektrisches Kfz-Nebenaggregat (10) nach Anspruch 6, wobei der Blattfederkontakt (50) brückenartig ausgebildet und in einer Kontaktöffnung (54) der Platine (40) angeordnet ist, und wobei der Blattfederkontakt (50) mit seinen beiden Längsenden mit der Gehäusemasse-Insel (64) verbunden ist.

8. Elektrisches Kfz-Nebenaggregat (10) nach einem der vorangegangenen Ansprüche 2-7, wobei die Gehäusemasse-Insel (60) über einen Blattfederkontakt (50) elektrisch unmittelbar mit der Trennwand (20) verbunden ist.

9. Elektrisches Kfz-Nebenaggregat (10) nach einem der vorangegangenen Ansprüche 2-8, wobei zwischen der Motorelektronik-Platine (40) und der Trennwand (20) eine elektrisch nicht-leitende Wärmeleitschicht (42) in einer definierten Dicke D vorgesehen ist.

10. Elektrisches Kfz-Nebenaggregat (10) nach einem der vorangegangenen Ansprüche 8 oder 9, wobei der Blattfederkontakt (50) durch eine elektrisch leitende Verbindungsschraube (52) mit der Trennwand (20) verbunden ist.

11. Verfahren zur Herstellung eines elektrischen Kfz-Nebenaggregats (10) nach Anspruch 9, wobei bei der Montage die Dicke D der Wärmeleitschicht (42) kapazitiv bestimmt wird, bevor der Blattfederkontakt (50) elektrisch leitend mit dem Gehäuse (15) bzw. der Trennwand (20) verbunden wird.

## Claims

1. Electric auxiliary device (10) for a motor vehicle, comprising
an electric drive motor (15) with stator-side motor coils (30),
an auxiliary device mechanism (12) driven by the drive motor (14),
a motor electronics circuit board (40) with motor electronics comprising control and power electronics (37) for controlling the drive motor (14), and
an electrically conductive auxiliary device housing (15),
wherein the motor electronics circuit board (40) comprises:
a vehicle ground island (60) adapted to be connected to the vehicle ground (80) via a ground terminal (70),
a circuit ground island (62) connected to the vehicle ground island (60) via an EMV filter element (63) configured as a RC filter, and
a housing ground island (64) connected to the vehicle ground island (60) via an EMV filter element (65) configured as a RC filter.

2. Electric auxiliary device (10) for a motor vehicle of claim 1, wherein an electrically conductive partition wall (20) is arranged in the auxiliary device housing (15), said wall being electrically connected to the housing (15) and separating a motor electronics chamber (17) from the drive motor and/or the device mechanism (12).

3. Electric auxiliary device (10) for a motor vehicle of claim 2, wherein the device mechanism (12) is a liquid pump with a pump rotor (24) and a pump stator (22), the partition wall (20) being cooled directly by the liquid pumped by the liquid pump.

4. Electric auxiliary device (10) for a motor vehicle of one of the preceding claims, wherein the vehicle ground island (60) is provided on the circuit board (40) at the edge of the circuit board (40) and immediately adjacent the housing (15).

5. Electric auxiliary device (10) for a motor vehicle of the preceding claim, wherein ground terminal (70) is guided to the outside from the vehicle ground island (60) approximately radially through the housing (15).

6. Electric auxiliary device (10) for a motor vehicle of one of the preceding claims, wherein the housing ground island (60) is directly electrically connected to the auxiliary device housing (15) via a leaf spring contact (50).

7. Electric auxiliary device (10) for a motor vehicle of claim 6, wherein the leaf spring contact (50) has a bridge-shaped design and is arranged in a contact opening (54) of the circuit board (40), and wherein the leaf spring contact (50) is connected to the housing ground island (64) by both of its longitudinal ends.

8. Electric auxiliary device (10) for a motor vehicle of one of the preceding claims 2-7, wherein the housing ground island (64) is directly electrically connected to the partition wall (20) via a leaf spring contact (50).

9. Electric auxiliary device (10) for a motor vehicle of one of the preceding claims 2-8, wherein an electrically non-conductive heat conducting layer (42) is provided in a defined thickness D between the motor electronics circuit board (40) and the partition wall (20).

10. Electric auxiliary device (10) for a motor vehicle of one of the preceding claims 8 or 9, wherein the leaf spring contact (50) is connected to the partition wall (20) via an electrically conductive connecting crew (52).

11. Method for manufacturing an electric auxiliary device (10) for a motor vehicle of claim 9, wherein, during assembly, the thickness D of the heat conducting layer (42) is determined in a capacitive manner before the leaf spring contact (50) is electrically connected to the housing (15) to the partition wall (20)

## Revendications

1. Agrégat auxiliaire (10) électrique d'un véhicule, avec
un moteur d'entraînement (14) électrique avec des bobines de moteur (30), côté stator,
un mécanisme d'agrégat (12) entrainé par ledit moteur d'entrainement (14),
un circuit imprimé (40) de l'électronique du moteur avec une électronique du moteur comportant une électronique de commande et de puissance (37) pour commander ledit moteur d'entrainement (14), et
un carter d'agrégat auxiliaire (15) électriquement conducteur,
ledit circuit imprimé (40) de l'électronique du moteur comportant:
un îlot de masse du véhicule (60) pouvant être relié à la masse du véhicule (80) à travers une borne de masse (70),
un îlot de masse du circuit (62) relié à l'îlot de masse du véhicule (60) à travers un élément de filtre CEM (63) réalisé sous forme d'un filtre RC, et
un îlot de masse du carter (64) relié à l'îlot de masse du véhicule (60) à travers un élément de filtre CEM (65) réalisé sous forme d'un filtre RC.

2. Agrégat auxiliaire (10) électrique d'un véhicule selon la revendication 1, dans lequel une paroi de séparation (20) électriquement conductrice est disposée dans ledit carter d'agrégat auxiliaire (15), reliée électriquement au carter (15), ladite paroi séparant une chambre de l'électronique du moteur (17) dudit moteur d'entrainement (14) et/ou dudit mécanisme d'agrégat (12).

3. Agrégat auxiliaire (10) électrique d'un véhicule selon la revendication 2, dans lequel ledit mécanisme d'agrégat (12) est une pompe à liquide avec un rotor de pompe (24) et un stator de pompe (22), ladite paroi de séparation (20) étant directement refroidie par le liquide pompé par ladite pompe à liquide.

4. Agrégat auxiliaire (10) électrique d'un véhicule selon l'une quelconque des revendications précédentes, dans lequel ledit îlot de masse du véhicule (60) est disposé sur le circuit imprimé (40) au bord du circuit imprimé (40) et directement adjacent au carter (15).

5. Agrégat auxiliaire (10) électrique d'un véhicule selon la revendication précédente, dans lequel une borne de masse (70) est guidée dudit îlot de masse du véhicule (60) approximativement dans la direction radiale à travers ledit carter (15) vers l'extérieur.

6. Agrégat auxiliaire (10) électrique d'un véhicule selon l'une quelconque des revendications précédentes, dans lequel ledit îlot de masse du carter (64) est directement relié électriquement au carter d'agrégat auxiliaire (15) par un contact ressort à lame (50).

7. Agrégat auxiliaire (10) électrique d'un véhicule selon la revendication 6, dans lequel ledit contact ressort à lame (50) est sous forme de ponte et est disposé dans une ouverture de contact (54) du circuit imprimé (40), et dans lequel ledit contact ressort à lame (50) est relié audit îlot de masse du carter (64) par ses deux extrémités longitudinales.

8. Agrégat auxiliaire (10) électrique d'un véhicule selon l'une quelconque des revendications précédentes 2-7, dans lequel ledit îlot de masse du carter (64) est directement électriquement relié à ladite paroi de séparation (20) par un contact ressort à lame (50).

9. Agrégat auxiliaire (10) électrique d'un véhicule selon l'une quelconque des revendications précédentes 2-8, dans lequel une couche conductrice de chaleur (42) avec une épaisseur D définie est prévue entre ledit circuit imprimé (40) de l'électronique du moteur et ladite paroi de séparation (20).

10. Agrégat auxiliaire (10) électrique d'un véhicule selon l'une quelconque des revendications précédentes 8 ou 9, dans lequel ledit contact ressort à lame (50) est relié à ladite paroi de séparation (20) par une vis de connexion (52) électriquement conductrice.

11. Procédé de fabrication d'un agrégat auxiliaire (10) électrique d'un véhicule selon la revendication 9, dans lequel l'épaisseur D de ladite couche conductrice de chaleur (42) est déterminée de façon capacitive lors de l'assemblage, avant ledit contact ressort à lame (50) est relié électriquement audit carter (15) ou à ladite paroi de séparation (20).
